# DEMANDE DE BREVET EUROPEEN

(11) **EP 4 481 414 A1**
(43) Date de publication de la demande: **25.12.2024**
(21) Numéro de dépôt: 24182938.1
(22) Date de dépôt: 18.06.2024
(51) Int. Cl.: G01R 31/3832

(54) **DISPOSITIF DE DÉTERMINATION DE L'ÉTAT DE CHARGE D'UNE BATTERIE, PROCÉDÉ ET VÉHICULE AUTOMOBILE ASSOCIÉS**

(30) Priorité: 22.06.2023 FR 2306485
(71) Demandeur: Ampere SAS, 92100 Boulogne-Billancourt (FR)
(72) Inventeur: Hiron, Christian, 78084 Guyancourt Cedex (FR); Lalere, Fabien, 78084 Guyancourt Cedex (FR)
(74) Mandataire: Renault Group

(57) **Abrégé**

Le dispositif de détermination de l'état de charge d'une batterie (2) comprend :
- des moyens de régulation (7),
- des moyens de mesure (8) du courant circulant à travers la batterie,
- des moyens de comparaison (14), et
- des moyens de réinitialisation (15) de l'état de charge de la batterie (2).

## Description

La présente invention concerne la détermination d'états de charge de batteries.

La présente invention concerne plus particulièrement un procédé de détermination de l'état de charge d'une batterie, un dispositif de détermination de l'état de charge d'une batterie, et un véhicule automobile comportant un tel dispositif.

Généralement, les véhicules automobiles sont équipés de batteries de type plomb acide.

L'état de charge d'une batterie est classiquement déterminé par comptage coulométrique à partir de mesures délivrées par une sonde mesurant la quantité d'électricité circulant aux bornes de la batterie.

Il est nécessaire de recaler régulièrement l'état de charge déterminé par comptage coulométrique pour corriger les erreurs de mesures.

Pour recaler l'état de charge de telles batteries, l'état de charge est réinitialisé à partir de la mesure de la tension en circuit ouvert de la batterie au repos depuis au moins une heure et d'une courbe reliant la valeur de la tension en circuit ouvert à un état de charge.

La variation de l'état de charge par rapport à la variation de la tension en circuit ouvert est suffisante pour déterminer avec précision l'état de charge de la batterie à partir de la variation de la tension en circuit ouvert aux bornes de ladite batterie.

Suite à l'évolution de la règlementation, les batteries de type plomb acide sont progressivement remplacées par des batteries lithium-ion de type Lithium Fer Phosphate/Graphite LFP/G.

Cependant, comme la variation de l'état de charge par rapport à la variation de la tension en circuit ouvert est faible, généralement inférieure à 1,7 mV par pourcentage de variation de l'état de charge pour un état de charge compris entre 40% et 70% de la charge maximale de la batterie, la méthode de recalage de l'état de charge de la batterie à partir de la tension en circuit ouvert de la batterie n'est pas suffisamment précise pour ce type de batterie.

Le document DE102012222457 propose une méthode pour déterminer l'état de charge d'une batterie lithium de type LPF/G à partir de la valeur de la résistance interne de la batterie.

Selon cette méthode, un système électronique provoque une impulsion de courant de valeur connue, et le saut de tension résultant est mesuré pour déterminer l'impédance de la batterie. L'état de charge est déterminé à partir de l'impédance et d'une table reliant des valeurs d'impédance à des états de charge.

Pour délivrer un état de charge précis, il est nécessaire que l'impédance varie suffisamment.

Cette condition est remplie au voisinage d'un état de charge nul (0%) ou plein (100%). Cependant, entre ces deux états de charge, la variation de l'impédance est trop faible pour déterminer un état de charge suffisamment précis.

Le but de l'invention est de pallier tout ou partie de ces inconvénients, notamment en réinitialisant l'état de charge d'une batterie à une valeur prédéterminée pour recaler l'état de charge.

L'invention a pour objet un procédé de détermination de l'état de charge d'une batterie.

Le procédé comprend les étapes suivantes :
(a) une régulation de la tension aux bornes de la batterie de sorte que ladite tension soit égale à une tension de référence, la valeur de la tension de référence étant choisie de sorte que la batterie soit en charge et est associée à un état de charge de référence de la batterie,
(b) une mesure du courant circulant à travers la batterie,
(c) une comparaison de l'intensité du courant mesurée à un seuil d'intensité de charge prédéterminé, et
(d) la réinitialisation de l'état de charge de la batterie l'intensité du courant mesurée est égale ou inférieure au seuil d'intensité de charge, l'état de charge de la batterie réinitialisée étant égal à l'état de charge de référence.

De préférence, la batterie est intégrée dans un véhicule automobile, le procédé comprend la mise en route du véhicule avant la mise en oeuvre des étapes (a) à (d).

Avantageusement, le procédé comprend l'actualisation de l'état de charge réinitialisé de la batterie à partir de la quantité d'électricité transitant par les bornes de la batterie.

De préférence, lorsque l'état de charge de référence de la batterie est inférieur ou égal à 70% de l'état de charge maximal de la batterie et l'état de charge de la batterie est réinitialisé, le procédé comprend la régulation de la tension aux bornes de la batterie de sorte que ladite tension soit égale à une première tension nominale, la première tension nominale étant supérieure à la tension de référence de manière à charger la batterie.

Avantageusement, lorsque l'état de charge de référence de la batterie est supérieur ou égal à 90% de l'état de charge maximal de la batterie et l'état de charge de la batterie est réinitialisé, le procédé comprend la régulation de la tension aux bornes de la batterie de sorte que ladite tension soit égale à une deuxième tension nominale, la deuxième tension nominale étant inférieure à la tension de référence de manière à décharger la batterie.

De préférence, la première tension nominale est égale à la deuxième tension nominale.

Avantageusement, la batterie est une batterie lithium fer phosphate/graphite.

Il est également proposé un dispositif de détermination de l'état de charge d'une batterie

Le dispositif comprend :
- des moyens de régulation configurés pour réguler la tension aux bornes de la batterie de sorte que ladite tension soit égale à une tension de référence, la valeur de la tension de référence étant choisie de sorte que la batterie soit en charge et est associée à un état de charge de référence de la batterie,
- des moyens de mesure de l'intensité du courant circulant à travers la batterie,
- des moyens de comparaison configurés pour comparer l'intensité du courant mesurée à un seuil d'intensité de charge prédéterminé, et
- des moyens de réinitialisation de l'état de charge de la batterie configurés pour réinitialiser l'état de charge à l'état de charge de référence lorsque l'intensité du courant mesurée est égale ou inférieure au seuil d'intensité de charge.

Avantageusement, le dispositif comporte en outre des moyens de comptage coulométrique configurés pour actualiser l'état de charge réinitialisé de la batterie à partir de la quantité d'électricité transitant par les bornes de la batterie.

Il est également proposé un véhicule automobile comportant une batterie et un dispositif de détermination de l'état de charge tel que défini précédemment et configuré pour déterminer l'état de charge de la batterie.

D'autres buts, caractéristiques et avantages de l'invention apparaîtront à la lecture de la description suivante, donnée uniquement à titre d'exemple non limitatif, et faite en référence aux dessins annexés sur lesquels :
[Fig 1]
   illustre schématiquement un exemple d'évolution temporelle de l'état de charge et d'un courant circulant dans une batterie LPF/G en charge;
[Fig 2]
   illustre schématiquement un exemple d'un véhicule automobile selon l'invention ;
[Fig 3]
   illustre schématiquement un premier exemple d'un procédé de détermination de l'état de charge d'une batterie selon l'invention ; et
[Fig 4]
   illustre schématiquement un deuxième exemple du procédé de détermination de l'état de charge de la batterie selon l'invention.

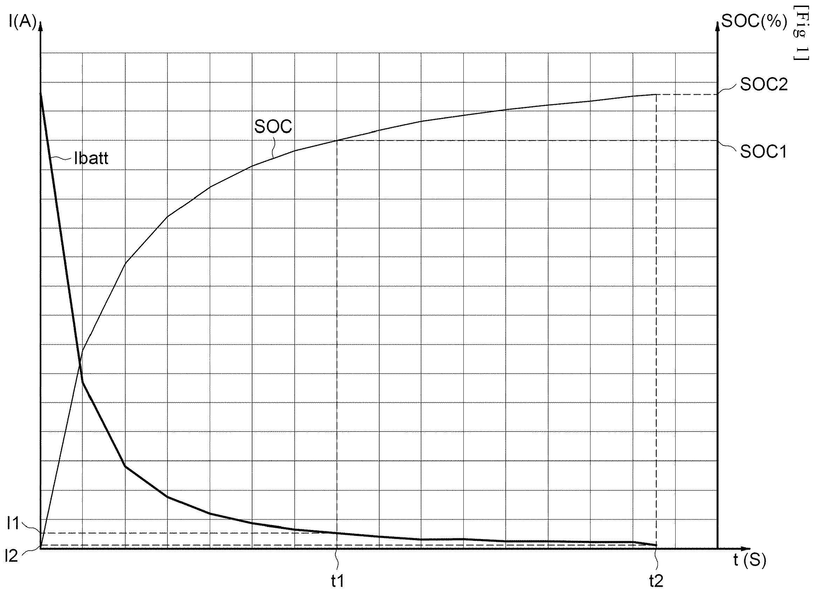

La figure 1 illustre un exemple d'évolution temporelle du courant Ibatt aux bornes de la batterie et de l'état de charge SOC (« State of Charge » en anglais) de la batterie lors de la charge de la batterie de type LPF/G sous une tension constante égale à la tension de la batterie ayant un SOC de 100%.

Un SOC de 100% est représentatif d'une batterie chargée au maximum de sa capacité de stockage, et une SOC de 0% est représentatif d'une batterie complètement déchargée.

A un instant t1, le courant Ibatt est égal à I1 et l'état de charge SOC est égal à SOC1 égal par exemple à 99%.

A un instant t2 ultérieure à l'instant t1, le courant Ibatt est égal à I2 et l'état de charge SOC est égal à SOC2 égal par exemple à 100%.

Lorsque la batterie est chargée sous une tension constante égale à la tension de la batterie ayant un SOC de 100% et que le courant Ibatt aux bornes de la batterie est compris entre I1 et I2, on peut supposer que le SOC de la batterie est au moins égal à SOC1, par exemple 99%.

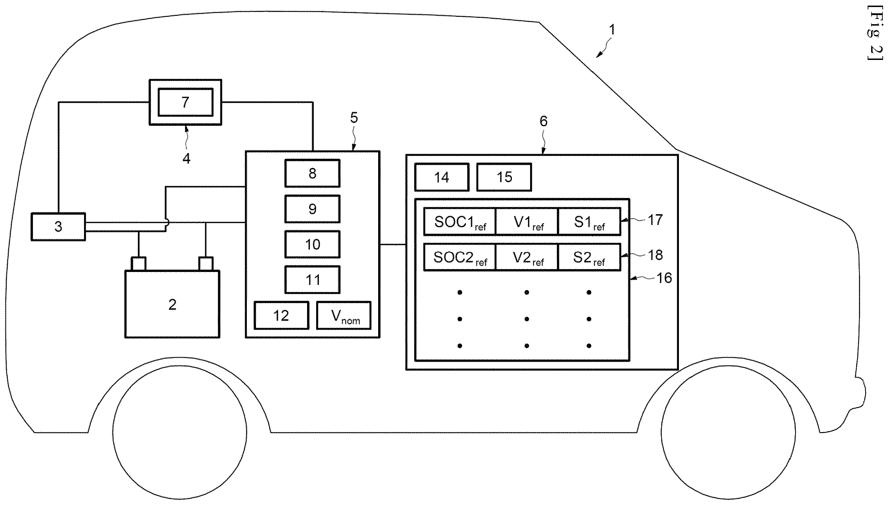

On se réfère à la figure 2 qui illustre schématiquement un exemple d'un véhicule automobile 1.

Le véhicule 1 comprend une batterie 2 par exemple lithium-ion de type LPF/G, une charge 3 électrique, un calculateur 4 de gestion d'énergie contrôlant la charge électrique 3, un système de contrôle 5 de la batterie 2, et un module de traitement 6.

La charge 3 reliée à la batterie 2 comprend par exemple un convertisseur de puissance ou un alternateur apte à charger la batterie 2.

Le calculateur 4 comprend des moyens de régulation 7 aptes à piloter la tension aux bornes de la charge électrique 3 reliée à la batterie 2 de sorte que les moyens de régulation 7 imposent la valeur de la tension aux bornes de la batterie 2, par exemple entre 12,5 V et 15 V.

Lorsque la valeur de la tension imposée par les moyens de régulation 7 aux bornes de la batterie 2 est supérieure à la tension aux bornes de la batterie 2, la batterie 2 est alimentée par la charge 3 de sorte que la batterie 2 est en charge.

Lorsque la valeur de la tension imposée par les moyens de régulation 7 est inférieure à la tension aux bornes de la batterie 2, la batterie 2 alimente la charge 3 de sorte que la batterie 2 est en décharge.

Le système de contrôle 5 comprend des moyens de mesure 8 de l'intensité d'un courant circulant aux bornes de la batterie 2 pour déterminer le courant circulant à travers la batterie 2, des moyens de comptage 9 coulométrique pour déterminer la quantité d'électricité transitant par les bornes de la batterie 2, des moyens de détermination 10 du SOC de la batterie 2 à partir des mesures délivrées par les moyens de comptage 9.

Les moyens de mesure 8 comprennent par exemple un capteur de courant.

Le système de contrôle 5 stocke en outre une valeur de tension nominale Vₙₒₘ égale à la tension nominale de la batterie 2 par exemple dans une mémoire (non représentée) du système 5.

Le système de contrôle 5 peut en outre comprendre des moyens de contrôle 11 déterminant un taux de dérive du SOC déterminé par les moyens de détermination 10 à partir des mesures délivrées par les moyens de mesure 8 et des mesures délivrées par les moyens de comptage 9.

Les moyens de contrôle 11 déterminent le taux de dérive du SOC à partir de la précision de mesure du capteur de courant et de l'auto décharge de cellules de la batterie 2 qui contribuent à la dérive du SOC.

La précision de mesure et l'auto décharge des cellules sont par exemple déterminés à partir d'au moins un modèle en fonction des kilomètres parcourus par le véhicule 1 ou la durée de vie des cellules.

Le système de contrôle 5 peut en outre comprendre des moyens de correction 12 corrigeant le SOC déterminé par les moyens de détermination 10 selon la perte de capacité de stockage de la batterie 2 liée au vieillissement de la batterie 2.

Le module de traitement 6 comprend des moyens de comparaison 14, des moyens de réinitialisation 15, et une mémoire 16.

La mémoire 16 stocke une pluralité de triplets 17, 18.

Chaque triplet 17, 18 comprend un état de charge de référence SOC1_{ref}, SOC2_{ref} de la batterie, une tension de référence V1_{ref}, V2_{ref}, et un seuil d'intensité de charge S1_{ref}, S2_{ref} prédéterminé.

La tension de référence V1_{ref}, V2_{ref} de chaque triplet 17, 18 est égale à la tension aux bornes de la batterie 2 lorsqu'elle a atteint l'état de charge de référence SOC1_{ref}, SOC2_{ref} associé à ladite tension de référence V1_{ref}, V2_{ref} dudit triplet.

Le seuil d'intensité de charge S1_{ref}, S2_{ref} de chaque triplet 17, 18 est choisi de sorte que lorsque le courant aux bornes de la batterie 2 est inférieur ou égal au seuil d'intensité de charge S1_{ref}, S2_{ref}, on peut supposer que le SOC de la batterie est au moins égal à l'état de charge de référence SOC1_{ref}, SOC2_{ref} associé audit triplet.

La tension de référence V1_{ref}, V2_{ref}, l'état de charge de référence SOC1_{ref}, SOC2_{ref}, et le seuil d'intensité de charge S1_{ref}, S2_{ref} prédéterminé sont déterminés pour chaque triplet 17, 18 par exemple empiriquement en analysant l'évolution temporelle du courant aux bornes de la batterie 2 et de l'état de charge SOC de la batterie 2 lors de la charge batterie sous une tension constante égale à la tension de de référence V1_{ref}, V2_{ref}, la figure 1 illustrant un exemple d'une telle évolution temporelle.

On suppose par exemple que dans ce qui suit, que l'état de charge de référence SOC1_{ref} d'un premier triplet 17 est égal à 70%, la tension de référence V1_{ref} est égale à 13,3 V, et le seuil d'intensité de charge S1_{ref} est choisi de sorte que lorsque le courant circulant à travers la batterie 2 est inférieur au seuil d'intensité de charge S1_{ref}, l'état de charge de la batterie 2 est supérieur ou égal à SOC1_{ref}.

On suppose en outre par exemple que dans ce qui suit que l'état de charge de référence SOC2_{ref} du deuxième triplet 18 est égal à 100%, la tension de référence V2_{ref} est égale à 14,4 V, et le seuil d'intensité de charge S2_{ref} est choisi de sorte que lorsque le courant circulant à travers la batterie 2 est inférieur au seuil d'intensité de charge S2_{ref}, l'état de charge de la batterie 2 est supérieur ou égal à SOC2_{ref}.

On suppose par exemple que la valeur de tension nominale Vₙₒₘ est égale à 13,6 V.

Les moyens de régulation 7, les moyens de mesure 8, les moyens de comptage coulométrique 9, les moyens de comparaison 14, et les moyens de réinitialisation 15 forment un dispositif de détermination de l'état de charge de la batterie 2.

L'état de charge SOC de la batterie 2 est généralement maintenu au-delà de 70% pour garantir l'alimentation d'un réseau de bord alimentant des systèmes de bord du véhicule 1 et notamment le dispositif de détermination de l'état de charge, et en deçà de 90% afin à réduire le vieillissement de la batterie 2 et pour conserver une acceptance de charge suffisante permettant le lissage de la tension du réseau de bord alimenté par la batterie 2.

A présent deux exemples d'un procédé de détermination de l'état de charge de la batterie 2 mettant en oeuvre le dispositif de détermination de l'état de charge sont détaillés.

De préférence, le procédé est mis en oeuvre par les moyens de contrôle 11 après la mise en route du véhicule 1.

Le procédé peut aussi être mis en oeuvre par les moyens de contrôle 11 lorsque le taux de dérive du SOC déterminé par les moyens de contrôle 11 est supérieur à un seuil de dérive prédéterminé.

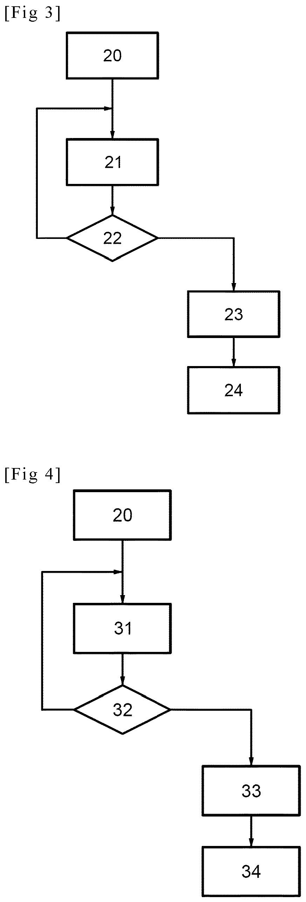

La figure 3 illustre un premier exemple d'un procédé de détermination de l'état de charge de la batterie.

On suppose que dans cet exemple le SOC de la batterie 2 déterminé par les moyens de détermination 10 est réinitialisé à l'état de charge de référence SOC1_{ref} du premier triplet 17 égal par exemple à 70%.

On suppose que dans une première étape 20, le véhicule 1 est mis en route.

Durant une étape 21, les moyens de contrôle 11 pilotent les moyens de régulation 7 de sorte que la tension aux bornes de la batterie 2 est égale à la tension de référence V1_{ref} du premier triplet 17.

Les moyens de mesure 8 mesurent l'intensité du courant circulant à travers les bornes de la batterie 2 et les moyens de comparaison 14 comparent le courant mesuré par les moyens de mesure 8 au seuil d'intensité de charge S1_{ref} du premier triplet 17.

Tant que l'intensité du courant mesurée par les moyens de mesure 8 est supérieure au seuil d'intensité de charge S1_{ref} (étape 22), le procédé se poursuit à l'étape 21.

Dès que l'intensité du courant mesurée par les moyens de mesure 8 est égale ou inférieure au seuil d'intensité de charge S1_{ref}, à l'étape 23, les moyens de réinitialisation 15 réinitialise le SOC de la batterie 2 à l'état de charge de référence SOC1_{ref}, en l'espèce à la valeur 70%.

Durant une l'étape 24, comme l'état de charge de la batterie 2 est égal à l'état de charge de référence SOC1_{ref} qui est inférieur ou égal à 70% de l'état de charge maximal de la batterie 2 et l'état de charge de la batterie est réinitialisé, les moyens de contrôle 11 commandent les moyens de régulation 7 de sorte que la tension aux bornes de la batterie 2 est égale à une première tension nominale par exemple égale à la tension nominale Vₙₒₘ par exemple égale à 13,6 V.

Comme la valeur de la tension de référence V1_{ref} est inférieure à la valeur de la première tension nominale, la batterie 2 est en charge.

Entre deux réinitialisations successives du SOC de la batterie 2, le SOC de la batterie est actualisé en permanence par les moyens de détermination 10 à partir de la quantité d'électricité transitant par les bornes de la batterie 2 déterminée par les moyens de comptage coulométrique 9.

La figure 4 illustre un deuxième exemple d'un procédé de détermination de l'état de charge de la batterie 2.

On suppose dans cet exemple que le SOC de la batterie 2 déterminé par les moyens de détermination 10 est réinitialisé à l'état de charge de référence SOC2_{ref} du deuxième triplet 18 égal par exemple à 100%.

On suppose que dans la première étape 20, le véhicule 1 est mis en route.

Durant une étape 31, les moyens de contrôle 11 pilotent les moyens de régulation 7 de sorte que la tension aux bornes de la batterie 2 est égale à la tension de référence V2_{ref} du deuxième triplet 18.

Les moyens de mesure 8 mesurent l'intensité du courant circulant à travers les bornes de la batterie 2 et les moyens de comparaison 14 comparent l'intensité du courant mesurée par les moyens de mesure 8 au seuil d'intensité de charge S2_{ref} du deuxième triplet 18.

Tant que l'intensité du courant mesurée par les moyens de mesure 8 est supérieure au seuil d'intensité de charge S2_{ref} (étape 32), le procédé se poursuit à l'étape 31.

Dès que le courant mesuré par les moyens de mesure 8 est égal ou inférieur au seuil d'intensité de charge S2_{ref}, à l'étape 33, les moyens de réinitialisation 15 réinitialise le SOC de la batterie 2 à l'état de charge de référence SOC2_{ref}, en l'espèce à la valeur 100%.

Durant une l'étape 34, comme l'état de charge de la batterie 2 est égal à l'état de charge de référence SOC2_{ref} qui est inférieur ou égal à 90% de l'état de charge maximal de la batterie et l'état de charge de la batterie est réinitialisé, les moyens de contrôle 11 commandent les moyens de régulation 7 de sorte que la tension aux bornes de la batterie 2 soit égale à une deuxième tension nominale par exemple égale à la tension nominale Vₙₒₘ par exemple égale à 13,6 V.

Les première et deuxième tensions nominales peuvent être identiques ou différentes.

Comme la valeur de la tension de référence V2_{ref} est supérieure à la valeur de la deuxième tension nominale, la batterie 2 est en décharge.

Entre deux réinitialisations successives du SOC de la batterie 2, le SOC de la batterie est actualisé en permanence par les moyens de détermination 10 à partir de la quantité d'électricité transitant par les bornes de la batterie 2 déterminée par les moyens de comptage coulométrique 9.

Le dispositif de détermination de l'état de charge permet de réinitialiser et déterminer l'état de charge de la batterie 2 ayant un profil de tension en circuit ouvert en fonction de l'état de charge présentant une faible pente, par exemple inférieure à 1,7 mV par unité d'état de charge de manière précise sur la plage d'état de charges de ladite batterie.

Bien entendu, la batterie 2 peut être différente d'une batterie lithium-ion de type LPF/G, par exemple une batterie sodium-ion.

## Revendications

1. Procédé de détermination de l'état de charge d'une batterie (2), **caractérisé en ce que** le procédé comprend les étapes suivantes :
(a) une régulation de la tension aux bornes de la batterie (2) de sorte que ladite tension soit égale à une tension de référence (V1_{ref}, V2_{ref}), la valeur de la tension de référence étant choisie de sorte que la batterie soit en charge et est associée à un état de charge de référence de la batterie (SOC1_{ref}, SOC2_{ref}),
(b) une mesure du courant circulant à travers la batterie,
(c) une comparaison de l'intensité du courant mesurée à un seuil d'intensité de charge (S1_{ref}, S2_{ref}) prédéterminé, et
(d) la réinitialisation de l'état de charge de la batterie lorsque l'intensité du courant mesurée est égale ou inférieure au seuil d'intensité de charge, l'état de charge de la batterie réinitialisée étant égal à l'état de charge de référence.

2. Procédé selon la revendication 1, dans lequel la batterie est intégrée dans un véhicule automobile (1), le procédé comprenant la mise en route du véhicule avant la mise en oeuvre des étapes (a) à (d).

3. Procédé selon la revendication 1 ou 2, le procédé comprenant l'actualisation de l'état de charge réinitialisé de la batterie à partir de la quantité d'électricité transitant par les bornes de la batterie.

4. Procédé selon l'une des revendications 1 à 3, dans lequel lorsque l'état de charge de référence (SOC1_{ref}) de la batterie (2) est inférieur ou égal à 70% de l'état de charge maximal de la batterie et l'état de charge de la batterie est réinitialisé, le procédé comprend la régulation de la tension aux bornes de la batterie de sorte que ladite tension soit égale à une première tension nominale, la première tension nominale étant supérieure à la tension de référence de manière à charger la batterie.

5. Procédé selon l'une des revendications 1 à 4, dans lequel lorsque l'état de charge de référence (SOC2_{ref}) de la batterie (2) est supérieur ou égal à 90% de l'état de charge maximal de la batterie et l'état de charge de la batterie est réinitialisé, le procédé comprend la régulation de la tension aux bornes de la batterie de sorte que ladite tension soit égale à une deuxième tension nominale, la deuxième tension nominale étant inférieure à la tension de référence de manière à décharger la batterie.

6. Procédé selon la revendication 5, dans lequel la première tension nominale est égale à la deuxième tension nominale.

7. Procédé selon l'une quelconque des revendications 1 à 6, dans lequel la batterie (2) est une batterie lithium fer phosphate/graphite.

8. Dispositif de détermination de l'état de charge d'une batterie, **caractérisé en ce que** le dispositif comprend :
- des moyens de régulation (7) configurés pour réguler la tension aux bornes de la batterie (2) de sorte que ladite tension soit égale à une tension de référence (V1_{ref}, V2_{ref}), la valeur de la tension de référence étant choisie de sorte que la batterie soit en charge et est associée à un état de charge de référence (SOC1_{ref}, SOC2_{ref}) de la batterie,
- des moyens de mesure (8) l'intensité du courant circulant à travers la batterie,
- des moyens de comparaison (14) configurés pour comparer l'intensité du courant mesurée à un seuil d'intensité de charge (S1_{ref}, S2_{ref}) prédéterminé, et
- des moyens de réinitialisation (15) de l'état de charge de la batterie (2) configurés pour réinitialiser l'état de charge à l'état de charge de référence (SOC1_{ref}, SOC2_{ref}) lorsque l'intensité du courant mesurée est égale ou inférieure au seuil d'intensité de charge (S1_{ref}, S2_{ref}).

9. Dispositif selon la revendication 8, comportant en outre des moyens de comptage (9) coulométrique configurés pour actualiser l'état de charge réinitialisé de la batterie (2) à partir de la quantité d'électricité transitant par les bornes de la batterie.

10. Véhicule automobile (1) comportant une batterie (2) et un dispositif de détermination de l'état de charge selon la revendication 8 ou 9 configuré pour déterminer l'état de charge de la batterie.
